# EUROPEAN PATENT APPLICATION

(11) **EP 2 325 874 A1**
(43) Date of publication of application: **25.05.2011**
(21) Application number: 09176737.6
(22) Date of filing: 23.11.2009
(51) Int. Cl.: H01L 21/336, H01L 29/78, H01L 29/423, H01L 29/40

(54) **Method of Forming a Transistor and Semiconductor Device**

(71) Applicant: NXP B.V., 5656 AG Eindhoven (NL)
(72) Inventor: Curatola, Gilberto, Redhill, Surrey RH1 1DL (GB); Fotopoulou, Kyriaki, Redhill, Surrey RH1 1DL (GB); Vellianitis, Georgios, Redhill, Surrey RH1 1DL (GB); Akil, Nader, Redhill, Surrey RH1 1DL (GB)
(74) Representative: Burton, Nick

(57) **Abstract**

Disclosed is a method of forming a transistor, comprising providing a substrate (1) having a pair of insulation regions (10) laterally separated by a channel region (16); and forming a metal control structures (18) on each of the insulation regions, wherein each metal control structure penetrates its insulation region by a depth (B), said metal control structures defining the gate of the transistor. An electronic device comprising such a transistor is also disclosed.

## Description

### FIELD OF THE INVENTION

The present invention relates to a method of forming a transistor, comprising providing a substrate having a pair of insulation regions laterally separated by a channel region.

The present invention further relates to a semiconductor device having a substrate comprising a transistor, said substrate comprising a pair of insulation regions laterally separated by a channel region of said transistor.

### BACKGROUND OF THE INVENTION

There are many semiconductor device applications that require semiconductor elements, e.g. transistors, to have high gate voltage capabilities. Example application domains comprise display drivers for thin film transistor (TFT) or light emitting diode (LED) based display panels and non-volatile memory applications, for instance in identification applications such as radiofrequency identification (RFID) chips. Such transistors may be required to cope with gate voltages in excess of 10V, thus requiring a substantial gate oxide, yet be required to have limited size as dictated by the footprint of the device.

In order to service these conflicting requirements, prior art solutions include cascoding arrangements in which multiple cascoded transistors act as a single high voltage transistor. This has the drawback of increased area, thus adding to the overall cost of the device.

Another prior art solution is the provision of dedicated high voltage transistors in a semiconductor process such as a CMOS technology, which tend to have thicker gate oxides than the standard transistors in the technology, such that the high voltage transistor can sustain increased voltages and has an improved reliability and lifetime. The drawback of this approach is that typically, additional process steps are required to implement the high voltage transistor in the given technology, such as extra mask steps, which also increases the overall cost of the device.

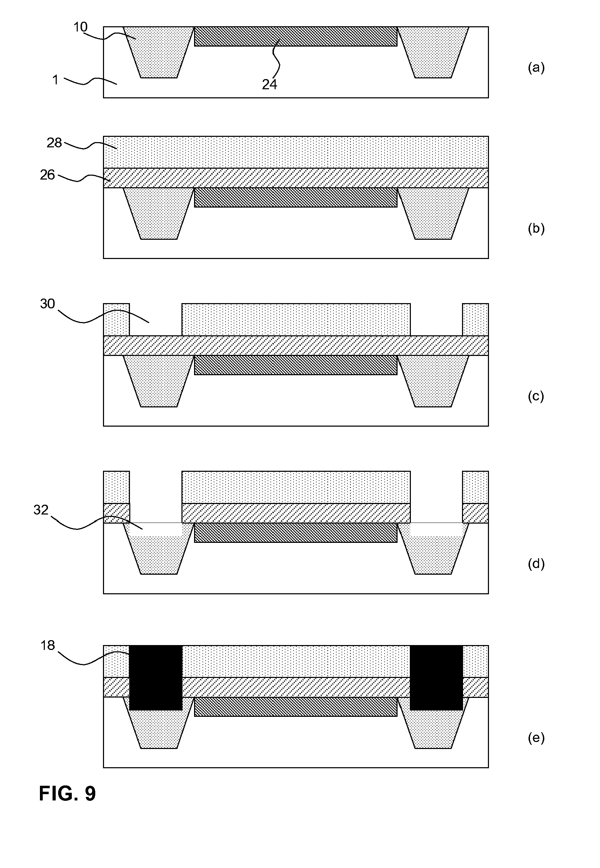

Recently, J. Sonsky et al. in "Towards universal and voltage-scalable high gate- and drain-voltage MOSFETs in CMOS", ISPDP Conference Proceedings, Barcelona 2009, pages 315-318, have disclosed a high voltage lateral gate CMOS transistor that can be realized without requiring additional process steps. This transistor comprises a channel region extending in between shallow trench insulation (STI) regions, with the STI regions each carrying a poly-Si lateral control gate. In operation, the lateral fringing capacitance defined by the poly-Si lateral gate, STI oxide and the channel region causes the opening of conduction channels along the sidewalls of the STI regions leading to current flow along these sidewalls. Such a high voltage transistor is relatively insensitive to mask misalignment when forming the lateral poly-Si gates because an increase in effective oxide thickness (EOT) on one side of the channel is offset by a reduction in EOT by the same amount at the other side, as explained by the description of FIG. 9 in this article. However, in these transistors, it is difficult to increase the lateral fringing capacitance to further improve the high voltage properties without significantly increasing the complexity and cost of the manufacturing process.

### SUMMARY OF THE INVENTION

The present invention seeks to provide a method of forming an improved lateral gate transistor.

The present invention further seeks to provide an improved lateral gate transistor that can be used for high voltage purposes.

According to an aspect of the present invention, there is provided a method of forming a transistor, comprising providing a substrate having a pair of insulation regions laterally separated by a channel region; and forming a metal control structures on each of the insulation regions, wherein each metal control structure penetrates its insulation region by a depth, said metal control structures defining the gate of the transistor.

The present invention is based on the realization that an aspect of the formation of metal structures on laterally displaced insulating regions such as the shallow trench insulation regions defining the area of the transistor, namely the penetration of the deposited metal into the insulating region may be utilized to increase the lateral fringe capacity of a transistor having lateral gates, thereby improving the voltage and current characteristics of the transistor. Compared to the transistor disclosed by Sonsky et al., the conduction channel along the side wall of the insulation region is significantly increased due to the presence of the metal penetrated into the insulation region.

In an embodiment, at least the penetrating portion of each metal control structure is separated from the channel region by a portion of the insulation region having a thickness, preferably a minimal thickness as dictated by the design rules of the semiconductor technology in which the transistor is formed. Since this thickness defines the equivalent oxide thickness (EOT) of the transistor, tuning this thickness, e.g. minimizing this thickness, can be used to control the properties of the transistor.

In an embodiment, the metal control structures are local interconnect layers. In many semiconductor technologies, including CMOS, it is possible to shape a metal contact in the form of a metal contact line, which is sometimes referred to as a contact bar or a local interconnect layer (LIL). Hence, the provision of metal lateral control gates in the form of LILs has the advantage that the manufacturing process of the transistor does not require additional processing steps, e.g. additional mask sets, thus facilitating the manufacture of an improved transistor without having to (significantly) increase its cost.

The method of the present invention may further comprise conventional processing steps such as for instance providing source and drain regions on opposite sides of the channel region and implanting an impurity into the channel region for controlling the threshold voltage of the transistor.

In accordance with another aspect of the present invention, there is provided a semiconductor device having a substrate comprising a transistor, said substrate comprising a pair of insulation regions laterally separated by a channel region of said transistor, the semiconductor device further comprising a metal control structure on each of the insulation regions, wherein each metal control structure penetrates its insulation region by a depth, said metal control structures defining the gate of the transistor. Such a transistor benefits from improved voltage and current characteristics at no (significant) additional expense, as previously explained.

In an embodiment, the semiconductor device is an identification device such as a RFID tag, in which case the transistor of the present invention may form part of the non-volatile memory of the tag.

The semiconductor device of the present invention may be successfully integrated into an apparatus, such as a display device or an identification system. Other suitable apparatus types for instance include mobile communication devices and computing systems.

### BRIEF DESCRIPTION OF THE EMBODIMENTS

Embodiments of the invention are described in more detail and by way of non-limiting examples with reference to the accompanying drawings, wherein:
FIG. 1 schematically depicts a top view of a transistor according to an embodiment of the present invention;
FIG. 2 schematically depicts a top view of a transistor according to another embodiment of the present invention;
FIG. 3-5 schematically depict cross sections of transistors according to several embodiments of the present invention;
FIG. 6 and 7 show tunneling electron microscope (TEM) images of a transistor manufactured in accordance with an embodiment of the present invention;
FIG. 8 schematically depicts a perspective cross section view of a transistor according to an embodiment of the present invention; and
FIG. 9 schematically depicts a non-limiting example embodiment of a method of forming a transistor of the present invention.

### DETAILED DESCRIPTION OF THE DRAWINGS

It should be understood that the Figures are merely schematic and are not drawn to scale. It should also be understood that the same reference numerals are used throughout the Figures to indicate the same or similar parts.

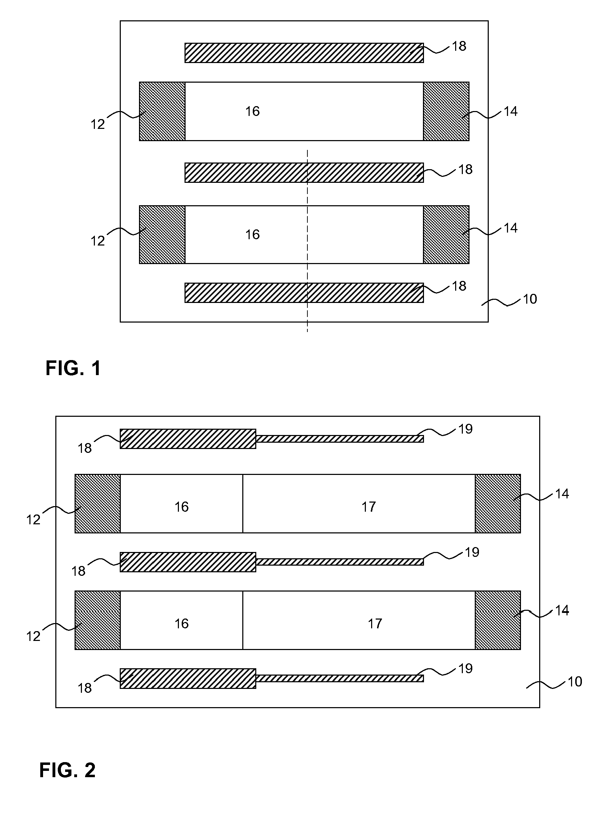

FIG. 1 shows a top view of a high-voltage transistor according to an embodiment of the present invention. Shallow trench insulation 10, which may be formed in a substrate in any suitable manner, surrounds respective channel regions 16 that extend lengthwise between a source region 12 and a drain region 14. Alongside the channel regions 16, metal lateral gate structures 18 are provided on the shallow trench insulation 10, preferably in the form of local interconnect layers, and which penetrate the shallow trench insulation 10 to a certain depth. Suitable metals may include elementary metals as well as alloys, such as Al, Cu, Ti, TiN, W and combinations thereof. Preferably, any metal may be used that is already used in the semiconductor technology of choice, such as CMOS, such that existing processing steps may be used to form the metal lateral gate structures at no additional cost. The metal lateral gates structures 18, e.g. local interconnect layers, may be formed in any suitable manner, for instance as shown in FIG. 9.

In FIG. 1, two parallel channel regions are shown by way of non-limiting example only. The advantage of using parallel channel regions 16 in combination with multiple metal lateral gates 18 is that the transistor performance may be increased, e.g. an increase in the total current drive current of the transistor at the limited cost of a modest increase of the footprint of the transistor. Alternatively, each channel region 16 may define an individual transistor having two parallel channels on opposite sides of an STI region, i.e. separated by the STI region 10.

Nevertheless, each shallow trench insulation region in the substrate may comprise any suitable number of parallel devices including a device having a single channel region 16 only. Moreover, it will be apparent to the skilled person that the transistor design may be varied in many ways without departing from the teachings of the present invention.

For instance, one such variation is shown in FIG. 2, where the drain regions 12 are extended with an extension region 17 of a conductivity type opposite to the conductivity type of the channel region 16, with the metal lateral gates 18 being extended with a field plate 19 running alongside the drain extension regions 17. Such drain extension regions may for instance be realized using layout-enables RESURF techniques as also explained in the aforementioned publication by Sonsky et al. Other routine variations will be apparent to the skilled person.

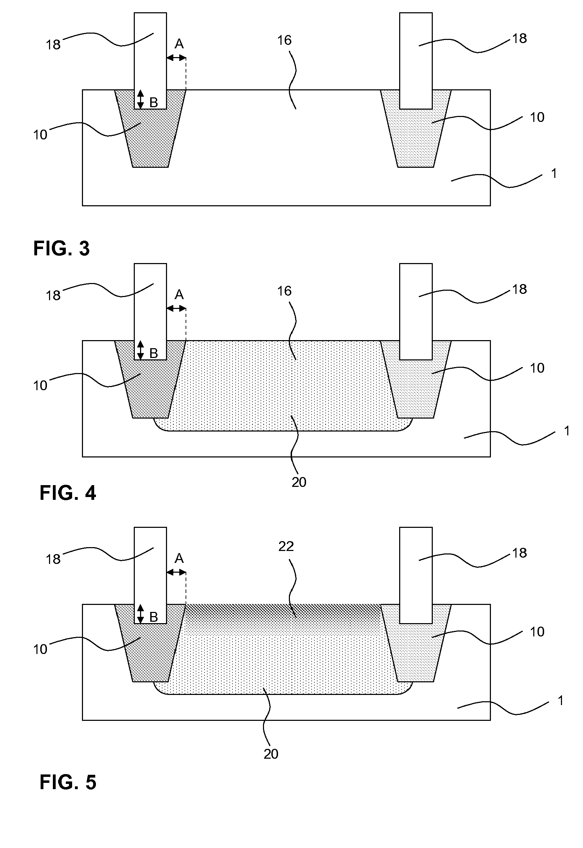

FIG. 3 shows a cross-section of a high voltage transistor as viewed along the dashed line in FIG. 1. As can be seen, the lateral control gates 18 penetrate the shallow trench insulation 10 in the substrate 1, or any other suitable insulation layer bordering the channel region 16, by a depth B. The lateral control gates 18 are further separated from the channel region by a portion of the shallow trench insulation having a thickness A. Misalignment of the formation of the lateral control gates 18 on the respective shallow trench insulation regions 10 may mean that the respective thicknesses of the portions of the shallow trench insulation regions 10 separating the respective metal lateral control gates 18 from the channel region 16 may be different. However, as already explained in FIG. 9 and its description in the publication by Sonsky et al., this does not significantly affect the linearity of the drain-source current (I_{DS}), in contrast to single gate transistors in which the gate is placed over the channel region, where variations in the gate oxide thickness have a significant effect on the performance of the transistor.

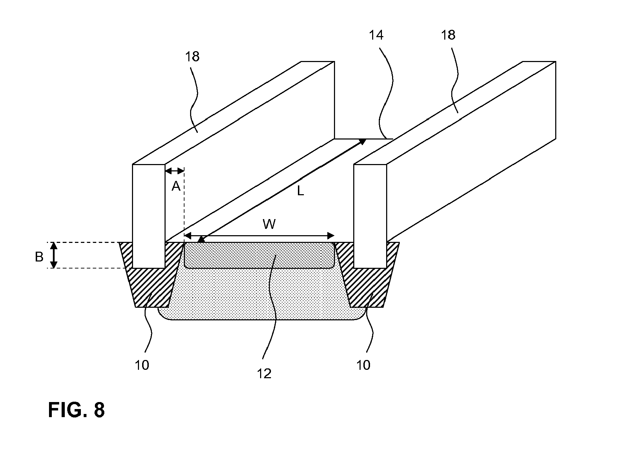

Parameters A and B have a direct correlation to the characteristics of the high voltage transistor. The thickness A of the portion of the shallow trench insulation 10 that spaces the metal lateral control gate 18 from the channel region 16 defines the effective EOT of the transistor, whereas the penetration depth B of the metal lateral control gate 18 into the shallow trench insulation 10 is correlated to the effective (channel) volume of the transistor, with the effective width of the channel defined by parameters W and L as shown in FIG. 8. In other words, the parameter B defines the extension of the channel depth into the substrate, which means that the parameter B has a direct correlation with the performance improvement with respect of the solution presented by J. Sonsky where the transistor is working via the fringe capacitance.

In particular, the penetration of the metal lateral control gate 18 into the shallow trench insulation 10 greatly improves the control exerted by the gate electrode over the inversion channel formed in the channel region 16. Preferably, the thickness A is chosen at the lower limit of the design rules in the given technology to yield the thinnest possible gate dielectric, thus yielding the lowest possible EOT as allowed by the design rules.

At this point, it is noted that the dielectric stack as disclosed in Sonsky et al. may also be present in the devices of the present invention. Such a gate stack may comprise multiple dielectric materials, which for instance may result from the different oxidation steps required for the gate stack formation and the spacer formation. Since the formation of the gate stack requires well-known techniques only, this is not further disclosed for reasons of brevity only.

The penetration depth B preferably is maximized to maximize the increase in the lateral fringing capacitance. It has been found that in a CMOS 140 nm process, penetration depths B between 50-100 nm can be achieved. This will be explained in more detail with the aid of FIG. 9. It should be understood that the present invention may be worked in any suitable semiconductor technology, e.g. CMOS technologies having different feature sizes.

In FIG. 3, the substrate 1 is a p-type silicon substrate by way of non-limiting example only. Any suitable substrate type may be used. Also, it should be appreciated that both nMOS and pMOS transistors may be realized. As previously mentioned, any suitable design variation that is compatible with the metal lateral gate structures 18 on insulation regions 10, e.g. STI regions, may be contemplated. For instance, for an NMOS transistor, the transistor may be realized in a p-well, or instead a masking layer may be included in the manufacturing process to prevent the p-well implementation from being formed in the substrate.

One such variation is shown in FIG. 4, wherein the p-type substrate 1 is of a first conductivity type, and further comprises a well 20 of opposite conductivity type in which the channel region 16 is defined. The substrate 1 may be a p-type material with the well 20 being an n-well or vice versa.

It may also be beneficial to tune the threshold voltage Vₜ of the transistor of the present invention. In an embodiment, shown in FIG. 5, an impurity 22 has been implanted into the channel region 16 to tune Vₜ. Since such implants are known per se, they will not be discussed in further detail for reasons of brevity only.

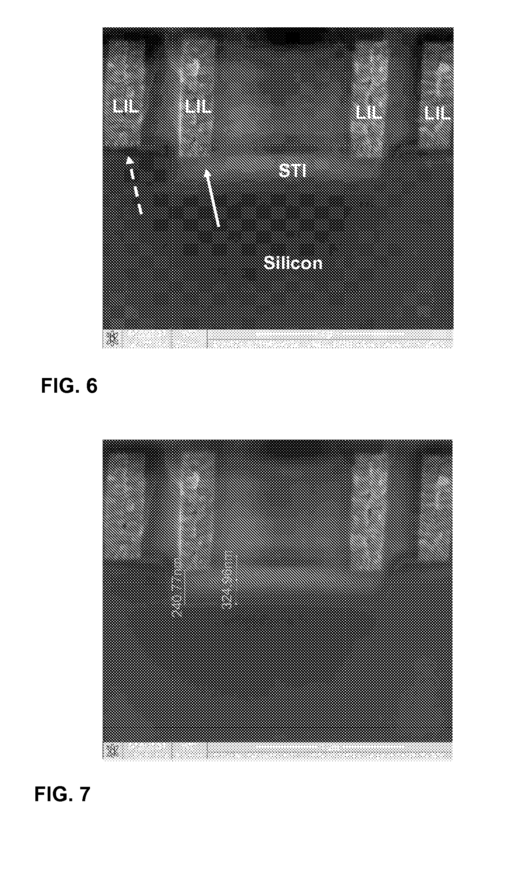

FIG. 6 shows a TEM image of a transistor manufactured in a CMOS 140 nm technology. The solid arrows identifies a first local interconnect layer formed on a STI whereas the dashed arrow identifies a further local interconnect layer formed on a silicide. As can be clearly derived from FIG. 6, the local interconnect layer has penetrated the STI, in contrast to the further interconnect layer, which has not penetrated the silicide. This penetration has been quantified in FIG. 7, in which it shown that the thickness of the STI is about 325 nm, whereas the thickness of the STI under the local interconnect layer is about 240 nm, thus showing a penetration B of around 85 nm.

FIG. 9 gives a non-limiting example of how a LIL penetrating the STI 10 may be formed. In step (a), a substrate 1 comprising STI regions 10 and a patterned further layer 24 in between the STI regions 10 is provided. The patterned further layer 24 may for instance be a patterned silicide layer present on the substrate contact regions such as the source and drain contact regions to lower the contact resistance of these regions. The further layer 24 typically has a higher resistance to a given etch recipe than the STI regions 10 This is because the etch recipes are typically chosen to stop on the low-resistance contact regions such that these regions do not get removed by the etch step.

In a next step (b), a silicon nitride layer 26 and a high density plasma oxide layer 28 are deposited over the substrate 10, after which a selective etch is performed in step (c) to etch a trench 30 in the high density plasma oxide layer 28 over the STI regions 10. This etch step is designed to stop on the silicon nitride layer 26. This is followed by a second etching step as shown in step (d), in which an etch recipe is used that is optimized to stop on the further layer 24, e.g. a silicide layer. However, due to the fact that the STI regions 10 are more susceptible to this etch recipe, the exposure of the STI regions 10 to this recipe causes the formation of an under-etch 32 in the STI regions 10. The depth of this under-etch may be controlled by tuning of the etch recipe and/or by varying the duration of the exposure of the STI regions 10 to the etch recipe. The etch recipe may contain any suitable chemical compounds such as carbon-based compounds, hydrogen, fluorine and oxygen and mixtures thereof. A non-limiting example of a suitable recipe is the standard recipe used in fast drak field etching.

Upon completion of the formation of the under-etch 32, the local interconnect layers 18 may be formed in any suitable manner. Any suitable material may be used. Preferably, the material used for the LIL 18 is tungsten.

In summary, a high-voltage transistor can be fabricated using existing semiconductor, e.g. CMOS, processing steps. Such a transistor may form part of an electronic device that may be used in e.g. the memory block (memory + periphery) of an RFID system. Such a device may be used for a wide range of applications; from passive tag (memory < 0.5 Kb) to smart cards 0.5 Mb). Alternatively, the transistor may form part of an electronic device that may be used as a display driver in suitable types of displays. Integration of the transistor of the present invention in electronic devices in other suitable application domains, e.g. mobile communication and computing, is also feasible.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. The word "comprising" does not exclude the presence of elements or steps other than those listed in a claim. The word "a" or "an" preceding an element does not exclude the presence of a plurality of such elements. The invention can be implemented by means of hardware comprising several distinct elements. In the device claim enumerating several means, several of these means can be embodied by one and the same item of hardware. The mere fact that certain measures are recited in mutually different dependent claims does not indicate that a combination of these measures cannot be used to advantage.

## Claims

1. A method of forming a transistor, comprising:
providing a substrate (1) having a pair of insulation regions (10) laterally separated by a channel region (16); and
forming a metal control structures (18) on each of the insulation regions, wherein each metal control structure penetrates its insulation region by a depth (B), said metal control structures defining the gate of the transistor.

2. The method of claim 1, wherein the step of forming the metal control structures (18) comprises forming a trench (32) in each of the insulation regions, and forming the metal control structures in said trenches.

3. The method of claim 1, wherein at least the penetrating portion of each metal control structure (18) is separated from the channel region (16) by a portion of the insulation region having a thickness (A).

4. The method of claim 1 or 2, wherein the metal control structures (18) are local interconnect layers.

5. The method of claim 1 or 2, further providing source (12) and drain (14) regions on opposite sides of the channel region (16).

6. The method of claim 1 or 2, wherein the insulation regions (10) are shallow trench insulation regions.

7. The method of claim 1 or 2, further comprising implanting an impurity (22) into the channel region (16) for controlling the threshold voltage of the transistor.

8. A semiconductor device having a substrate (1) comprising a transistor, said substrate comprising a pair of insulation regions (10) laterally separated by a channel region (16) of said transistor, the semiconductor device further comprising a metal control structure (18) on each of the insulation regions, wherein each metal control structure penetrates its insulation region by a depth (B), said metal control structures defining the gate of the transistor.

9. The semiconductor device of claim 8, wherein at least the penetrating portion of each metal control structure (18) is separated from the channel region (16) by a portion of the insulation region (10) having a thickness (A).

10. The semiconductor device of claim 8 or 9, wherein the metal control structures (18) are local interconnect layers.

11. The semiconductor device of claim 8 or 9, wherein the transistor further comprises source (12) and drain (14) regions on opposite sides of the channel region (16).

12. The semiconductor device of claim 8 or 9, wherein the insulation regions (10) are shallow trench insulation regions.

13. The semiconductor device of claim 8 or 9, wherein the device is an identification device.

14. An apparatus comprising the semiconductor device of any of claims 8-13.
